# EUROPEAN PATENT APPLICATION

(11) **EP 4 340 133 A1**
(43) Date of publication of application: **20.03.2024**
(21) Application number: 22195251.8
(22) Date of filing: 13.09.2022
(51) Int. Cl.: H01R 4/38, G01R 1/20, H01R 12/58, H01R 12/52

(54) **CONTACT ELEMENT FOR A SHUNT RESISTOR, SHUNT ASSEMBLY AND ELECTRICAL MEASUREMENT DEVICE**

(71) Applicant: TE Connectivity Germany GmbH, 64625 Bensheim (DE)
(72) Inventor: Karabiyik, Hamdi, 67346 Speyer (DE); Mueller, Christoph, 67346 Speyer (DE); Eberle, Marcus, 67346 Speyer (DE)
(74) Representative: Grünecker Patent- und Rechtsanwälte PartG mbB

(57) **Abstract**

The object of the present invention is to improve the accuracy of electrical measurement devices (4) utilizing shunt resistors (8), in particular, by reducing the temperature influenceability of the measurement. The object is achieved by a contact element (1) for connecting an electrical sensor (6) to a shunt resistor (8) in an electrically conductive manner, wherein the contact element (1) comprises a first side (12) and a second side (14), the second side (14) facing away from the first side (12), wherein, on the first side (12), a terminal section (18) of the contact element (1) for connecting the contact element (1) to the electrical sensor (6) is arranged, wherein, on the second side (14), at least one contact surface (26) for abutting against a surface (28) of the shunt resistor (8) protrudes, wherein the contact element (1) comprises an attachment section (34) for fastening the contact element (1) to the shunt resistor (8), and wherein the at least one contact surface (26) is spaced apart from the attachment section (34) in a radial direction (60). Due to the at least one contact surface (26) being spaced apart from the attachment section (34), it is possible to electrically contact the shunt resistor (8) by means of the at least one contact surface (26) at a location as close as possible to temperature insensitive resistive elements (68) of the shunt resistor (8). Thereby, the influence that any other components of the shunt resistor (8) have on the resistance value of the conductive path between the contact element (1) and the resistive elements (68) of the shunt resistor (8) is eliminated or at least minimized. The object is further achieved by a shunt assembly (2) comprising the inventive contact element (1) as well as by an electrical measurement device (4) comprising the inventive shunt assembly (2).

## Description

### Technical Field to which the Invention relates and Background Art

The present invention relates to a contact element for connecting an electrical sensor to a shunt resistor in an electrically conductive manner. Further, the present invention relates to a shunt assembly comprising a contact element and a shunt resistor. Moreover, the present invention relates to an electrical measurement device comprising a shunt assembly and an electrical sensor.

In the field of electrical engineering, many applications require the measurement of amperage and/or voltage within an electrical circuit. Especially for measurements of current values too large to be directly measured by an ammeter, a so-called shunt resistor is arranged in the circuit in parallel with a voltmeter. The shunt resistor is a special type of resistor with a relatively low resistance, so that virtually all of the current to be measured will flow through the shunt resistor. The concrete resistance of the shunt resistor is chosen so that the resultant voltage drop is high enough to be measurable with the voltmeter, but low enough not to disrupt the circuit. The voltage across the shunt resistor is proportional to the current flowing through it and thus, the measured voltage can be scaled to directly display the current value.

For accurate scaling, however, the actual resistance value of the shunt resistor has to be known as precisely as possible, since it influences the proportionality factor between the measured voltage and the current value. For this purpose, resistive elements having a minimal temperature coefficient of their resistance value are integrated in the shunt resistor. That is, the resistance value of the resistive elements is virtually independent of the (operating) temperature. This is important, since electrical circuits tend to heat up under load.

Nevertheless, the shunt resistor as a whole (including all its remaining components) exhibits a certain temperature dependency in its overall resistance value. Therefore, temperature will inevitably have an undesired impact on the measurement results of the current value.

Thus, it is desirable to minimize said temperature impact and to improve measurement accuracy.

### Object to be achieved

The object of the present invention is to provide means for generally improving the measurement accuracy of electrical measurement devices utilizing shunt resistors, and for reducing the temperature influenceability of the measurement, in particular.

### Disclosure of Invention

The object is achieved by providing a contact element for connecting an electrical sensor to a shunt resistor in an electrically conductive manner, wherein the contact element comprises a first side and a second side, the second side facing away from the first side, wherein, on the first side, a terminal section of the contact element for connecting the contact element to the electrical sensor is arranged, wherein, on the second side, at least one contact surface for abutting against a surface of the shunt resistor protrudes, wherein the contact element further comprises an attachment section for fastening the contact element to the shunt resistor, and wherein the at least one contact surface is spaced apart from the attachment section in a radial direction.

The technical effects and advantages achieved by the above solution are as follows:
By arranging the terminal section on the first side, while having the at least one contact surface protrude on the second side, the contact element can be used to create an electrically conductive path between the electrical sensor and the shunt resistor. Herein, the terminal section may be adapted for connection with e.g., a sensor probe, a sensor wire and/or a printed circuit board (PCB) of the electric sensor. An exemplary electric sensor may be a voltmeter.

Due to the at least one contact surface being spaced apart from the attachment section in the radial direction, the contact element can electrically contact the shunt resistor at a location distanced from and independent of the location of its attachment. Herein, the radial direction is a direction traverse, preferably perpendicular to the distance between the first side and the second side.

Hence, on one hand, the contact element can be fastened to the shunt resistor by means of the attachment section at a location that is particularly suited for attachment of the contact element, be it due to its geometric structure, its solderability or its weldability. This will be explained in detail further below.

On the other hand, it is possible to electrically contact the shunt resistor by means of the at least one contact surface at a location as close as possible to the above-described resistive elements of the shunt resistor. Thereby, the influence that any other components of the shunt resistor have on the resistive value of the conductive path between the inventive contact element and the resistive elements of the shunt resistor is eliminated or at least minimized. Consequently, the influence that the other components of the shunt resistor have on the resistive value of the conductive path between the electrical sensor and the shunt resistor is also eliminated or at least minimized. In other words, the share of the temperature independent resistive elements in the conductive path between the electrical sensor and the shunt resistor can be increased, while the share of the other (temperature dependent) components can be decreased. Overall, this results in less to no temperature dependency of the resistance value of the conductive path between the electrical sensor and the shunt resistor.

Thus, the measurement accuracy of electrical measurement devices utilizing shunt resistors can be improved by means of the inventive contact element, particularly since the temperature influenceability of the measurement is reduced by means of the inventive contact element.

The above solution may be further improved by adding one or more of the following optional features. Each of the following optional features is advantageous on its own and may be combined independently with any other optional feature.

According to a first embodiment with simple manufacturability, the contact element may be a stamped and bent part made of sheet metal, in particular copper or a copper alloy. The terminal section, the attachment section and the at least one contact surface may be monolithically interconnected on the stamped and bent part. Herein, the at least one contact surface may face away from the terminal section and/or towards the same direction as the attachment section.

Owing primarily to the stamping process, the at least one contact surface may be convexly bulged out on the second side. Accordingly, the contact element may comprise, on the first side, at least one indentation opposite the at least one contact surface. Said indentation may be concavely recessed. This configuration saves material costs, as the at least one bulged out contact surface does not have to be created on massive/solid material.

Alternatively, the at least one contact surface may be spike-shaped, pyramid-shaped, cylinder-shaped, star-shaped or have any other shape protruding from the second side, in particular in a direction away from the first side.

Optionally, the at least one contact surface may comprise a coating, plating or brazing of a rare metal (e.g. silver) or rare metal alloy for reduced contact resistance.

A stable structure of the contact element can be achieved, if the at least one contact surface and the attachment section are arranged on a plate-shaped and/or ring-shaped segment of the contact element. Herein, said plate-shaped and/or ring-shaped segment provides a solid basis for the at least one contact surface and the attachment section. Further, said plate-shaped and/or ring-shaped segment of the contact element may form the first side and the second side. Accordingly, the first side may be arranged opposite of the second side with respect to said plate-shaped and/or ring-shaped segment.

According to a further embodiment, the terminal section may extend away from said plate-shaped and/or ring-shaped segment. In particular, the terminal section may protrude, preferably perpendicularly from the first side. This increases the distance between the electrical sensor and the shunt resistor that can be bridged by the contact element. In other words, a greater design flexibility can be achieved for the relative positioning of the electrical sensor and the shunt resistor. The distance however should not be too long otherwise the contact element itself would represent a significant temperature dependent resistance.

The terminal section may be configured for example as a press-fit pin adapted for insertion into a via of a printed circuit board (PCB) of the electric sensor. Alternatively, the terminal section may be configured as a crimp barrel, to which a sensor wire of the electric sensor can be crimped. Of course, other types of connection means suitable for connecting the contact element to the electric sensor may also be used in the terminal section.

A simple structure of the contact element can be obtained when the at least one contact surface and the attachment section are separated by a notch or groove. In other words, the notch or groove may be arranged between the at least one contact surface and the attachment section. Further, the notch or groove may be formed on the second side. In particular, the notch or groove may be formed in the above plate-shaped and/or ring-shaped segment of the contact element.

According to another embodiment of the contact element, the at least one contact surface and the attachment section may be interconnected by an arched section. In particular, the arched section may be a part of the plate-shaped and/or ring-shaped segment. Due to the presence of the arched section, the contact element, especially the plate-shaped and/or ring-shaped segment exhibits a larger area moment of inertia against bending compared to an entirely flat plate-shaped and/or ring-shaped segment of the same diameter. Thus, the structural stability of the contact element is increased.

In order to avoid sharp edges and tension peaks at the at least one contact surface, at least a portion of the at least one contact surface may be rounded off. In particular, said portion may be circular and/or spherical and/or toroidal. That is, said portion of the at least one contact surface may have the shape of a circle segment, a sphere segment or a torus segment. Of course, the at least one contact surface may also have the shape of a circle segment, a sphere segment or a torus segment in its entirety.

According to another embodiment of the contact element, the at least one contact surface may extend one of continuously and discontinuously around the attachment section. This increases design flexibility and allows the at least one contact surface to be optimized for specific applications e.g., depending on the required surface area. Further, the at least one contact surface may extend around the entire attachment section in a circumferentially closed manner. This embodiment exhibits a greater positional stability, since the contact element can abut against the surface of the shunt resistor at multiple contact points around the attachment section.

Optionally, the contact element may comprise a plurality of contact surfaces, which are arranged around the attachment section, preferably in a circular arrangement. The plurality of contact surfaces may be mutually spaced apart in the circumferential direction. Further, the plurality of contact surfaces may be distributed evenly or unevenly around the attachment section, depending on the application. Moreover, the plurality of contact surfaces may be mutually coplanar. Thus, the plurality of contact surfaces can all abut against the surface of the shunt resistor in the same plane. This further improves positional stability of the contact element when abutting against the surface of the shunt resistor.

As mentioned above, the contact element can be fastened to the shunt resistor by means of the attachment section. For this, the attachment section may comprise a through-hole. The through-hole may reach from the first side to the second side. Further, the through-hole may extend through the plate-shaped and/or ring-shaped segment of the contact element. Thus, the contact element is attachable to the shunt resistor, in particular to a screw hole of the shunt resistor with a simple fastening element, such as a screw or bolt. Herein, the screw hole may be located in a connection terminal of the shunt resistor and distanced from the resistive element of the shunt resistor. This will be further explained in detail below.

When attaching the contact element to the shunt resistor, the screw may be passed through the screw hole of the shunt resistor, the though-hole of the contact element and screwed into a threaded bore e.g., of a sensor housing. Likewise, the bolt may be passed through the screw hole of the shunt resistor, the though-hole of the contact element, but used in combination with a nut and a threadless bore of the sensor housing. In both cases, the at least one contact surface is oriented to abut against the surface of the shunt resistor. Hence, the screw or bolt can be utilized to exert the required normal force on the at least one contact surface, when abutting against the surface of the shunt resistor.

Optionally, the attachment section may comprise a guiding collar surrounding the through-hole. The guiding collar may be cylindrical, funnel-shaped, nozzle-shaped or dome-shaped. Further, the guiding collar may be adapted to fit into the screw hole of the shunt resistor. Preferably, the guiding collar protrudes from the second side and comprises a lead-in chamfer at a distal end facing away from the second side. Thus, the guiding collar facilitates the attachment process of the contact element by functioning as a guiding aid when positioning the contact element relative to the shunt resistor.

A base of the guiding collar may be located on the second side. In particular, the base of the guiding collar may be located in the notch or groove. Thus, the guiding collar may still be spaced apart from the at least one contact surface.

Alternatively or cumulatively, the guiding collar may also protrude from the first side in order to improve its visibility for an assembly line worker. Moreover, the guiding collar protruding from the first side may provide a gripping section for ease of handling of the contact element by the assembly line worker.

As an addition or alternative to the screw, the guiding collar may be adapted to engage in a press-fit with the screw hole of the shunt resistor, hence reinforcing or establishing the attachment of the contact element to the shunt resistor. Of course, the through-hole may also be omitted and the attachment section may be provided instead with a press-fit pin adapted to engage in a press-fit with the screw hole of the shunt resistor. Further, the attachment section may also be configured alternatively as a solder pad or weld pad.

The initial object is also achieved by providing a shunt assembly comprising at least one contact element and a shunt resistor, wherein the shunt resistor comprises at least one connection terminal and at least one resistive element arranged adjacent to each other, and wherein the at least one contact element abuts against an edge between the at least one connection terminal and the at least one resistive element. More precisely, at said edge, the at least one contact element abuts against the at least one connection terminal and not the at least one resistive element, which tends to develop an oxide layer. Said edge may form a border or transition between the at least one connection terminal and the at least one resistive element. At said edge, the at least one connection terminal may end in the direction towards the at least one resistive element.

Due to the at least one contact element abutting against the edge between the at least one connection terminal and the at least one resistive element, any electrical sensor connected to the shunt resistor via the at least one contact element will have less material with a temperature dependent resistance value (e.g. the material of the connection terminal) in its conductive path towards the at least one resistive element of the shunt resistor. This results in less to no temperature dependency of the resistance value of the conductive path between the electrical sensor and the shunt resistor. Hence the inventive shunt assembly achieves the initial object.

According to a possible embodiment of the shunt assembly, the at least one contact element may be configured according to the above-described embodiments. In particular, the at least one contact element of the shunt assembly may be a contact element according to any one of the claims directed to the contact element (see claim set of the present application). Thereby, the shunt assembly may additionally profit from the respective technical effects and advantages described above.

The at least one connection terminal may be made of copper or a copper alloy. In particular, the at least one connection terminal may be configured as a terminal plate. Further, the at least one connection terminal may comprise at least one screw hole as already mentioned above. Preferably, the at least one connection terminal may comprise multiple screw holes e.g., one for attachment of the at least one contact element and one for connecting the shunt resistor with the circuit of which the current values are to be measured.

The at least one resistive element may be comprised of or consist of resistance alloys such as Manganin, Constantan, Isaohm or any other conductive material with a low thermal variation of its resistivity. Optionally, the shunt resistor may comprise a plurality of resistive elements according to the required total resistance of the shunt resistor.

The initial objective is also achieved by an electrical measurement device comprising a shunt assembly according to the embodiments described above and at least one electrical sensor, wherein the at least one electrical sensor is connected to the at least one connection terminal of the shunt resistor by means of the at least one contact element. The electrical measurement device benefits from the above-described technical effect and advantage of the shunt assembly and the contact element. In particular, temperature dependency of the resistive value of the conductive path between the at least one electrical sensor and the shunt resistor is eliminated or at least reduced. Thereby, measurement accuracy of the at least one electrical sensor is improved in that the measured current values are not influenced by the temperature or only to a negligible extent.

According to a possible embodiment of the electrical measurement device, the electrical measurement device may comprise at least one screw and a sensor housing in which the at least one electrical sensor is accommodated. As already described above, the shunt resistor may comprise at least one screw hole for passing the at least one screw. Further, the sensor housing may comprise at least one threaded bore for threadably receiving the at least one screw. Moreover, the sensor housing may be attached to the shunt resistor by means of the at least one screw. This allows the electrical measurement device to be assembled in a simple manner.

The shunt resistor may comprise two connection terminals separated by the at least one resistive element. Accordingly, the shunt assembly may comprise two contact elements, one contact element abutting against the edge between the first connection terminal and the at least one resistive element, and the other contact element abutting against the edge between the second connection terminal and the at least one resistive element.

To achieve the parallel arrangement, mentioned at the outset, the two contact elements can be readily used to create two electrically conductive paths between the electrical sensor and the shunt resistor, effectively connecting the shunt resistor in parallel with the electrical sensor. Preferably, the two contact elements are each positioned on opposite sides of the resistive element, such that the at least one resistive element is parallel with the electrical sensor.

Each contact element is preferably arranged between the shunt resistor and the at least one sensor in order to fulfill a bridging function between the shunt resistor and the at least one sensor. In particular, the terminal section of each contact element is arranged inside of the sensor housing, while the attachment section and the at least one contact surface of each contact element are arranged outside of the sensor housing.

Optionally, each contact element comprises an anchoring section arranged between its terminal section and its attachment section. The anchoring section of each contact element may be tab-shaped and configured to engage in a form-fit or press-fit connection with the sensor housing. In particular, the sensor housing may comprise for each contact element a slot, shaped in a manner complementary to the respective anchoring section and adapted to receive the anchoring section. This advantageously allows all contact elements to be preassembled with the sensor housing in a toolless manner.

In the following, exemplary embodiments of the invention are described with reference to the drawings. The embodiments described and shown in the drawings, are for explanatory purposes only.

The combination of features shown in the embodiments may be changed according to the foregoing description. For example, a feature which is not shown in an embodiment but described above may be added if the technical effect associated with this feature is beneficial for a particular application. Vice versa, a feature shown as part of an embodiment may be omitted as described above, if the technical effect associated with this feature is not needed in a particular application.

In the drawings, elements that correspond to each other with respect to function and/or structure have been provided with the same reference numeral.

In the drawings,
- Fig. 1: shows a schematic representation of a perspective view of a contact element according to a possible embodiment of the present disclosure;
- Fig. 2: shows a schematic representation of a perspective view of a contact element according to another possible embodiment of the present disclosure;
- Fig. 3: shows a schematic representation of an exploded view of an electrical measurement device according to a possible embodiment of the present disclosure;
- Fig. 4: shows a schematic representation of a sectional view of the electrical measurement device according to the embodiment shown in Fig. 3; and
- Fig. 5: shows a schematic representation of a detail V of the sectional view of Fig. 4.

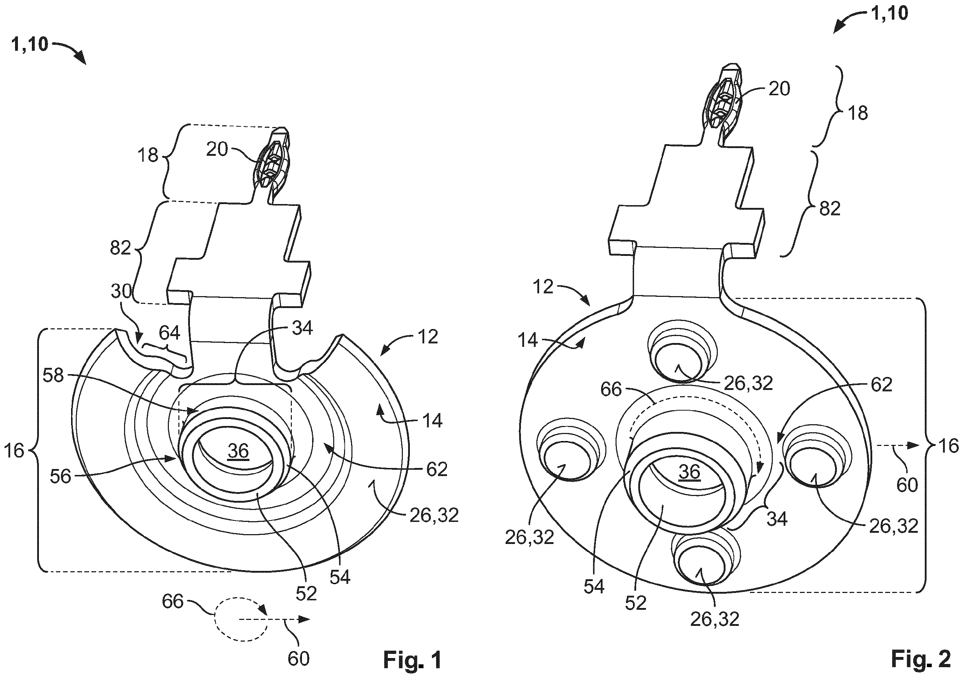

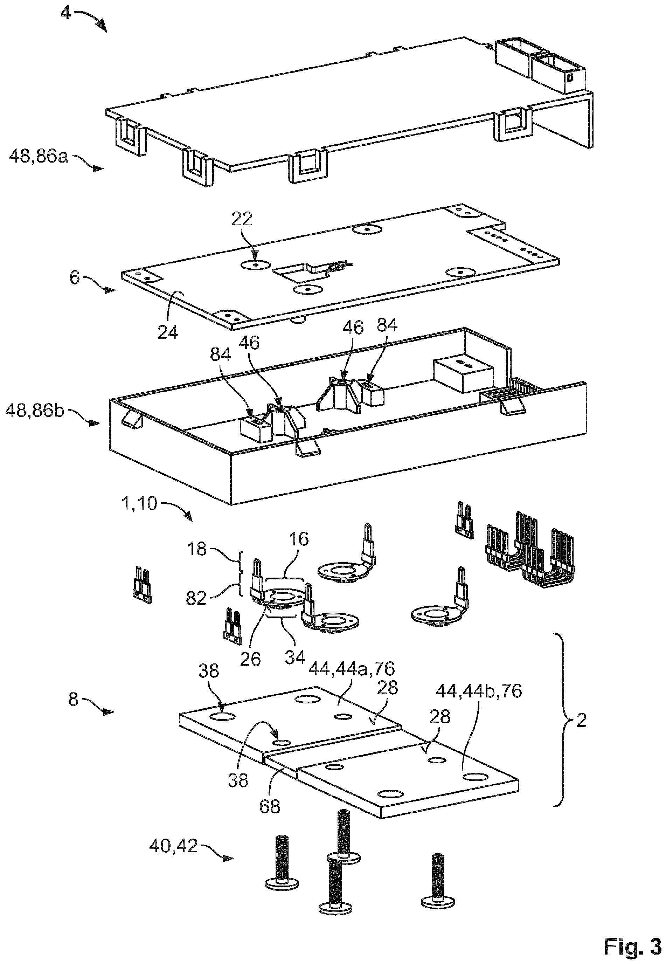

First, the structure of possible embodiments of a contact element 1 according to the present invention is explained with reference to the exemplary embodiments shown in Figs. 1 and 2. Further on, Figs. 3 to 5 are used to explain the structure of possible embodiments of a shunt assembly 2 and an electrical measurement device 4 for measuring current values and/or voltage values of a circuit (not shown).

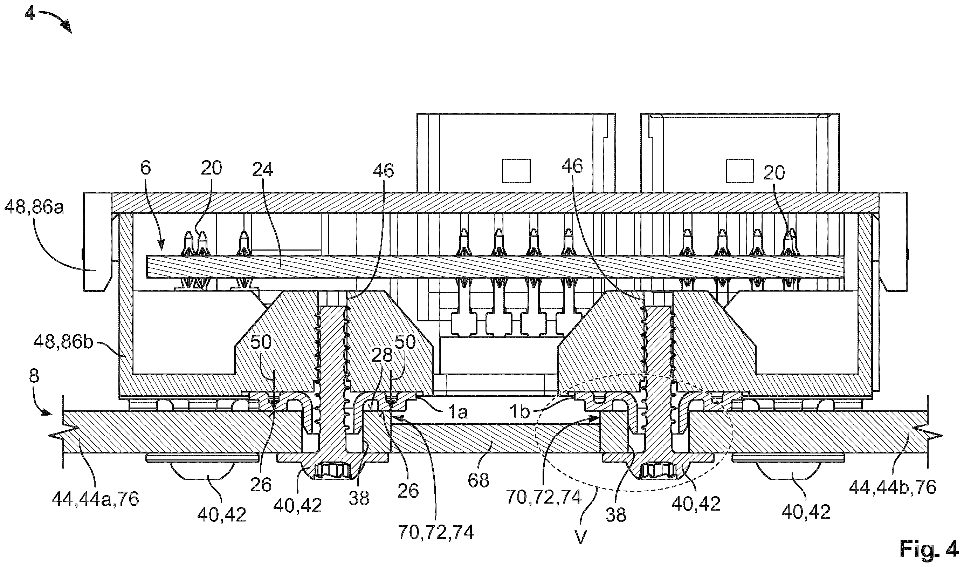

Fig. 1 shows a perspective view of the contact element 1 according to one possible embodiment of the present disclosure. The contact element 1 serves for connecting an electrical sensor 6 to a shunt resistor 8 in an electrically conductive manner (see Fig. 4). For this purpose, the contact element 1 may be a stamped and bent part 10 made of sheet metal, in particular copper or a copper alloy.

The contact element 1 comprises a first side 12 and a second side 14, the second side 14 facing away from the first side 12. The first side 12 and the second side 14 may be formed on a plate-shaped and/or ring-shaped segment 16 of the contact element 1. Accordingly, the first side 12 may be arranged opposite of the second side 14 with respect to said plate-shaped and/or ring-shaped segment 16.

On the first side 12, a terminal section 18 of the contact element 1 for connecting the contact element 1 to the electrical sensor 6 is arranged. The terminal section 18 may be configured for example as a press-fit pin 20 adapted for insertion into a via 22 of a printed circuit board 24 of the electric sensor 6 (see Fig. 3). Alternatively, the terminal section 18 may also be configured as a crimp barrel (not shown), to which a sensor wire (not shown) of the electric sensor 6 can be crimped. The terminal section 18 may extend away from the plate-shaped and/or ring-shaped segment 16. In particular, the terminal section 18 may protrude, preferably perpendicularly from the first side 12.

On the second side 14, at least one contact surface 26 for abutting against a surface 28 of the shunt resistor 8 protrudes (see Fig. 3). As can be seen in Fig. 1, the at least one contact surface 26 may be convexly bulged out on the second side 14. Accordingly, the contact element 1 may comprise, on the first side 12, at least one indentation 30 opposite the at least one contact surface 26. As can further be seen in Fig. 1, said indentation 30 may be concavely recessed.

Further, at least a portion 32 of the at least one contact surface 26 may be rounded off. In particular, said portion 32 may be toroidal. That is, said portion 32 of the at least one contact surface 26 may have the shape of a torus segment. Alternatively or cumulatively, said portion 32 may be circular and/or spherical. In other words, said portion 32 of the at least one contact surface 26 may also have the shape of a circle segment or a sphere segment.

According to an alternative embodiment, not shown, the at least one contact surface 26 may be spike-shaped, pyramid-shaped, cylinder-shaped, star-shaped or have any other shape protruding from the second side 14, in particular in a direction away from the first side 12.

As can be seen in Fig. 1, the contact element 1 further comprises an attachment section 34 for fastening the contact element 1 to the shunt resistor 8. For this purpose, the attachment section 34 may comprise a through-hole 36. The through-hole 36 may lead from the first side 12 to the second side 14. Further, the through-hole 36 may extend through the plate-shaped and/or ring-shaped segment 16 of the contact element 1. Thus, the contact element 1 is attachable to the shunt resistor 8, in particular to a screw hole 38 of the shunt resistor 8 with a simple fastening element 40, such as a screw 42 (see Fig. 4). As will be further explained in detail below, the screw hole 38 may be located in a connection terminal 44 of the shunt resistor 8.

When attaching the contact element 1 to the shunt resistor 8, the screw 42 may be passed through the screw hole 38 of the shunt resistor 8, the through-hole 36 of the contact element 1 and screwed into a threaded bore 46 e.g., of a sensor housing 48 of the electrical sensor 6 (see Fig. 4). Hence, the screw 42 can be utilized to exert the required normal force 50 on the at least one contact surface 26, when abutting against the surface 28 of the shunt resistor 8.

To aid the attachment process, the attachment section 34 may comprise a guiding collar 52 surrounding the through-hole 36. The guiding collar 52 may be nozzle-shaped as shown in Fig. 1. Alternatively, the guiding collar may also be cylindrical, funnel-shaped or dome-shaped.

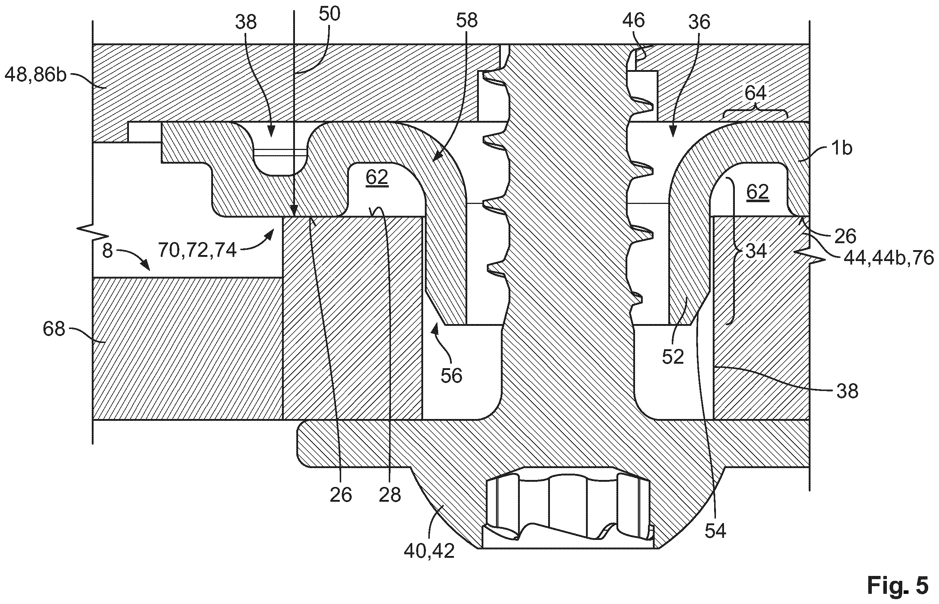

As can be seen from Fig. 5, the guiding collar 52 may be adapted to fit into the screw hole 38 of the shunt resistor 8. Preferably, the guiding collar 52 protrudes from the second side 14 and comprises a lead-in chamfer 54 at a distal end 56 facing away from the second side 14. Optionally, the guiding collar 52 may be adapted to engage in a press-fit with the screw hole 38 of the shunt resistor 8. In this case, the attachment by means of the screw 42 can be reinforced or even omitted entirely.

Further, in Fig. 5 it is shown that a base 58 of the guiding collar 52 may be located on the second side 14. However, according to an embodiment not shown, the guiding collar 52 may also protrude from the first side 12.

Returning to Fig. 1, the terminal section 18, the attachment section 34 and the at least one contact surface 26 may be monolithically interconnected on the stamped and bent part 10. Herein, the at least one contact surface 26 may face away from the terminal section 18 and towards the same direction as the attachment section 34. In particular, the at least one contact surface 26 and the attachment section 34 may be arranged on the plate-shaped and/or ring-shaped segment 16 of the contact element 1.

The at least one contact surface 26 is spaced apart from the attachment section 34 in a radial direction 60. Herein, the radial direction 60 is a direction traverse, preferably perpendicular to the distance between the first side 12 and the second side 14. In particular, the at least one contact surface 26 and the attachment section 34 are separated by a notch 62. In other words, the notch 62 may be arranged between the at least one contact surface 26 and the attachment section 34. Further, the notch may be formed on the second side 14. Moreover, the notch 62 may be formed in the plate-shaped and/or ring-shaped segment 16 of the contact element 1.

Although separated by the notch 62, the at least one contact surface 26 and the attachment section 34 may be interconnected by an arched section 64 (see Fig. 5). In particular, the arched section 64 may be a part of the plate-shaped and/or ring-shaped segment 16.

Further, the at least one contact surface 26 may extend continuously or discontinuously around the attachment section 34. In the embodiment shown in Fig. 1, the at least one contact surface 26 only extends continuously around three quarters of the attachment section. Around the remaining quarter of the attachment section, the at least one contact surface 26 is discontinued. However, according to an embodiment not shown, the at least one contact surface 26 may also extend around the entire attachment section 34 in a circumferentially closed manner.

According to the embodiment shown in Fig. 2, the contact element 1 may comprise a plurality of contact surfaces 26, which are arranged around the attachment section 34, preferably in a circular arrangement. The plurality of contact surfaces 26 may be mutually spaced apart in the circumferential direction 66. Further, the plurality of contact surfaces 26 may be distributed evenly around the attachment section 34. Depending on the application, the distribution of the plurality of contact surfaces 26 may also be uneven.

Further, the plurality of contact surfaces 26 may be mutually coplanar. Thus, the plurality of contact surfaces 26 can all abut against the surface 28 of the shunt resistor 8 in the same plane (see Fig. 4). This improves the positional stability of the contact element 1 when abutting against the surface 28 of the shunt resistor 8.

In Fig. 3, the shunt assembly 2 comprising at least one contact element 1 and a shunt resistor 8 is depicted. The at least one contact element 1 may be configured according to the above described embodiments (e.g. of Fig. 1 and 2). The shunt resistor 8 comprises at least one connection terminal 44 and at least one resistive element 68 arranged adjacent to each other.

As shown in the detailed view of Fig. 5, the at least one contact element 1 abuts against an edge 70 between the at least one connection terminal 44 and the at least one resistive element 68. More precisely, at said edge 70, the at least one contact element 1 abuts against the at least one connection terminal 44 and not the at least one resistive element 68, which tends to develop an oxide layer (not shown). Still, only a minimal amount of material of the at least one connection terminal 44 lies in the conductive path between the at least one contact element 1 and the at least one resistive element 68, due to the proximity to said edge 70.

Further, said edge 70 may form a border 72 or transition 74 between the at least one connection terminal 44 and the at least one resistive element 68. In particular, the at least one connection terminal 44 may end at said edge 70 in the direction towards the at least one resistive element 68.

The at least one connection terminal 44 may be made of copper or a copper alloy. In particular, the at least one connection terminal 44 may be configured as a terminal plate 76. Further, the at least one connection terminal 44 may comprise at least one screw hole 38 as already described above. Preferably, the at least one connection terminal 44 may comprise multiple screw holes e.g., one for attachment of the at least one contact element 1 and one for connecting the shunt resistor 8 with the circuit (not shown) of which the current values are to be measured.

As shown in Fig. 3, the shunt resistor 8 may comprise two connection terminals 44a, 44b separated by the at least one resistive element 68. Accordingly, the shunt assembly 2 may comprise two or more contact elements 1a, 1b, the first contact element 1a abutting against the edge 70 between the first connection terminal 44a and the at least one resistive element 68, and the second contact element 1b abutting against the edge 70 between the second connection terminal 44b and the at least one resistive element 68 (see Fig. 4).

The at least one resistive element 68 may be comprised of or consist of resistance alloys such as Manganin, Constantan, Isaohm or any other conductive material with a low thermal variation of its resistivity. According to an optional embodiment, not shown, the shunt resistor 8 may comprise a plurality of resistive elements 68 according to the required total resistance of the shunt resistor 8.

Fig. 3 further shows the electrical measurement device 4 comprising the shunt assembly 2 according to the above described embodiments and at least one electrical sensor 6. The at least one electrical sensor 6 is provided with a printed circuit board 24 comprising a measurement circuit configured for measuring current values and/or voltage values.

The at least one electrical sensor 6, in particular the printed circuit board 24 is connected to the at least one connection terminal 44 of the shunt resistor 8 by means of the at least one contact element 1. In order to achieve a parallel arrangement between the shunt resistor 8 and the at least one electrical sensor 6, the two contact elements 1a, 1b may be provided to create two electrically conductive paths between the at least one electrical sensor 6 and the shunt resistor 8, effectively connecting the shunt resistor 8 in parallel with the electrical sensor 6. Preferably, the two contact elements 1a, 1b are each positioned on opposite sides of the at least one resistive element 68, such that the at least one resistive element 68 is in parallel with the electrical sensor 6.

As already mentioned above, the electrical measurement device 4 may comprise at least one screw 42 and a sensor housing 48 in which the at least one electrical sensor 6 is accommodated. Likewise, the shunt resistor 8 may comprise at least one screw hole 38 for passing the at least one screw 42. Further, the sensor housing 48 may comprise at least one threaded bore 46 for threadably receiving the at least one screw 42. Moreover, the sensor housing 48 may be attached to the shunt resistor 8 by means of the at least one screw 42 (see Fig. 5). Optionally, a plurality of screws 42, screw holes 38 and threaded bores 46 may be provided, depending on the number of contact elements 1 that the electrical measurement device 4 comprises (see Fig. 4).

Each contact element 1 is preferably arranged between the shunt resistor 8 and the at least one electrical sensor 6. In particular, the terminal section 18 of each contact element 1 is arranged inside of the sensor housing 48, while the attachment section 34 and the at least one contact surface 26 of each contact element 1 are arranged outside of the sensor housing 48. The sensor housing 48 in turn rests on the first side 12 of each contact element 1.

Optionally, each contact element 1 may comprise an anchoring section 82 arranged between its terminal section 18 and its attachment section 34. The anchoring section 82 of each contact element 1 may be tab-shaped and configured to engage in a form-fit or press-fit connection with the sensor housing 48. In particular, the sensor housing 48 may comprise for each contact element 1 a slot 84, shaped in a manner complementary to the respective anchoring section 82. The slot 84 receives the anchoring section 82.

In the shown embodiment of Fig. 3, a two-part sensor housing 48 comprised of two housing halves 86a, 86b is provided. The housing halves 86a, 86b may be configured for being clipped together. Alternatively, the housing halves 86a, 86b may also be glued, welded, soldered or screwed together.

### REFERENCE NUMERALS

- 1, 1a, 1b: contact element
- 2: shunt assembly
- 4: electrical measurement device
- 6: electrical sensor
- 8: shunt resistor
- 10: part
- 12: first side
- 14: second side
- 16: segment
- 18: terminal section
- 20: press-fit pin
- 22: via
- 24: printed circuit board
- 26: contact surface
- 28: surface
- 30: indentation
- 32: portion
- 34: attachment section
- 36: through-hole
- 38: screw hole
- 40: fastening element
- 42: screw
- 44, 44a, 44b: connection terminal
- 46: threaded bore
- 48: sensor housing
- 50: normal force
- 52: guiding collar
- 54: lead-in chamfer
- 56: distal end
- 58: base
- 60: radial direction
- 62: notch
- 64: arched section
- 66: circumferential direction
- 68: resistive element
- 70: edge
- 72: border
- 74: transition
- 76: terminal plate
- 82: anchoring section
- 84: slot
- 86a, 86b: two housing half

## Claims

1. Contact element (1) for connecting an electrical sensor (6) to a shunt resistor (8) in an electrically conductive manner, wherein the contact element (1) comprises a first side (12) and a second side (14), the second side (14) facing away from the first side (12), wherein, on the first side (12), a terminal section (18) of the contact element (1) for connecting the contact element (1) to the electrical sensor (6) is arranged, wherein, on the second side (14), at least one contact surface (26) for abutting against a surface (28) of the shunt resistor (8) protrudes, wherein the contact element (1) comprises an attachment section (34) for fastening the contact element (1) to the shunt resistor (8), and wherein the at least one contact surface (26) is spaced apart from the attachment section (34) in a radial direction (60).

2. Contact element (1) according to claim 1, wherein the contact element (1) comprises, on the first side (12), at least one indentation (30) opposite the at least one contact surface (26).

3. Contact element (1) according to claim 1 or 2, wherein the at least one contact surface (26) and the attachment section (34) are arranged on a plate-shaped and/or ring-shaped segment (16) of the contact element (1).

4. Contact element (1) according to claim 3, wherein the terminal section (18) extends away from the plate-shaped and/or ring-shaped segment (16).

5. Contact element (1) according to any one of claims 1 to 4, wherein the at least one contact surface (26) and the attachment section (34) are separated by a notch (62).

6. Contact element (1) according to any one of claims 1 to 5, wherein the at least one contact surface (26) and the attachment section (34) are interconnected by an arched section (64).

7. Contact element (1) according to any one of claims 1 to 6, wherein at least a portion (32) of the at least one contact surface (26) is circular and/or spherical and/or toroidal.

8. Contact element (1) according to any one of claims 1 to 7, wherein the at least one contact surface (26) extends one of continuously and discontinuously around the attachment section (34).

9. Contact element (1) according to any one of claims 1 to 8, wherein the contact element (1) comprises a plurality of contact surfaces (26), which are arranged around the attachment section (34).

10. Contact element (1) according to any one of claims 1 to 9, wherein the attachment section (34) comprises a through-hole (36) and a guiding collar (52) surrounding the through-hole (36).

11. Contact element (1) according to claim 10, wherein a base (58) of the guiding collar (52) is located on the second side (14).

12. Contact element (1) according to claim 10 or 11, wherein the guiding collar (52) protrudes from the first side (12) and/or the second side (14).

13. Shunt assembly (2) comprising at least one contact element (1) and a shunt resistor (8), wherein the shunt resistor (8) comprises at least one connection terminal (44) and at least one resistive element (68) arranged adjacent to each other, and wherein the at least one contact element (1) abuts against an edge (70) between the at least one connection terminal (44) and the at least one resistive element (68).

14. Electrical measurement device (4) comprising a shunt assembly (2) according to claim 13 and at least one electrical sensor (6), wherein the at least one electrical sensor (6) is connected to the at least one connection terminal (44) of the shunt resistor (8) by means of the at least one contact element (1).

15. Electrical measurement device (4) according to claim 14, wherein the electrical measurement device (4) comprises at least one screw (42) and a sensor housing (48) in which the at least one electrical sensor (6) is accommodated, wherein the shunt resistor (8) comprises at least one screw hole (38) for passing the at least one screw (42), wherein the sensor housing (48) comprises at least one threaded bore (46) for receiving the at least one screw (42), and wherein the sensor housing (48) is attached to the shunt resistor (8) by means of the at least one screw (42).
